# EUROPÄISCHE PATENTANMELDUNG

(11) **EP 4 565 018 A1**
(43) Veröffentlichungstag der Anmeldung: **04.06.2025**
(21) Anmeldenummer: 24216591.8
(22) Anmeldetag: 29.11.2024
(51) Int. Cl.: H05K 7/14

(54) **BACKPLANE-SYSTEM**

(30) Priorität: 29.11.2023 DE 102023133345
(71) Anmelder: MESSRING GmbH, 82205 Gilching (DE)
(72) Erfinder: Remmelberger, Daniel, 82205 Gilching (DE)
(74) Vertreter: Grünecker Patent- und Rechtsanwälte PartG mbB

(57) **Zusammenfassung**

Die Erfindung betrifft ein Backplane-System für Umgebungen, die Vibrationen und/oder Stößen ausgesetzt sind, das ein Gehäuse, das eine Gehäuserückwand aufweist, an der eine Backplane-Platine mit mindestens einem Steckverbinder befestigt ist, und ein Modul aufweist, das in das Gehäuse in einer Einschubrichtung einführbar ist und eine Modulplatine aufweist, die mit einer Modulrückwand verbunden ist, die mindestens einen Steckkontakt aufweist, wobei der mindestens eine Steckkontakt mit dem mindestens einen Steckverbinder mindestens eine Steckverbindung ausbildet, wenn das Modul in der Einschubrichtung in eine Endposition in das Gehäuse eingeschoben ist. Erfindungsgemäß ist ein Vorsprung fest an der Gehäuserückwand angeordnet, der durch die Backplane-Platine reicht und einen von der Gehäuserückwand entfernten Endabschnitt aufweist, der in eine Öffnung in der Modulrückwand in Einschubrichtung einführbar ist, wenn das Modul in Einschubrichtung in die Endposition gebracht wird, wobei der Endabschnitt und die Öffnung derart ausgebildet sind, dass diese eine Auslenkung der Modulrückwand gegenüber der Backplane-Platine senkrecht zur Einschubrichtung derart begrenzen, dass die mindestens eine Steckverbindung geschont wird.

## Beschreibung

Die vorliegende Erfindung betrifft ein Backplane-System für Umgebungen, die Vibrationen und/oder Stößen ausgesetzt sind, nach dem Oberbegriff des unabhängigen Anspruchs 1.

Ein derartiges Backplane-System weist ein Gehäuse, das eine Gehäuserückwand aufweist, an der eine Backplane-Platine mit mindestens einem Steckverbinder befestigt ist, und ein Modul auf, das in das Gehäuse in einer Einschubrichtung einführbar ist und eine Modulplatine aufweist, die mit einer Modulrückwand verbunden ist, die mindestens einen Steckkontakt aufweist, wobei der mindestens eine Steckkontakt mit dem mindestens einen Steckverbinder mindestens eine Steckverbindung ausbildet, wenn das Modul in der Einschubrichtung in eine Endposition in das Gehäuse eingeschoben ist.

Wenn derartige Backplane-Systeme in Umgebungen, die Vibrationen und/oder Stößen ausgesetzt sind, wie zum Beispiel im Automobil- oder Luftfahrbereich oder vorzugsweise im Crashtestbereich, eingesetzt werden, sind die bekannten Backplane-Systeme fehler- und defektanfällig und erlauben keine anhaltende Nutzung des Backplane-Systems.

Aufgabe der vorliegenden Erfindung ist es, ein derartiges Backplane-System anzugeben, dass eine verbesserte Lebensdauer und Funktionsweise in Umgebungen, die Vibrationen und/oder Stößen ausgesetzt sind, ermöglicht.

Die Aufgabe wird gelöst durch die Merkmale des unabhängigen Anspruchs 1.

Demnach liegt eine erfindungsgemäße Lösung der Aufgabe vor, wenn ein Vorsprung fest an der Gehäuserückwand angeordnet ist, der durch die Backplane-Platine reicht und einen von der Gehäuserückwand entfernten Endabschnitt aufweist, der in eine Öffnung in der Modulrückwand in Einschubrichtung einführbar ist, wenn das Modul in Einschubrichtung in die Endposition gebracht wird, wobei der Endabschnitt und die Öffnung derart ausgebildet sind, dass diese eine Auslenkung der Modulrückwand gegenüber der Backplane-Platine senkrecht zur Einschubrichtung derart begrenzen, dass die mindestens eine Steckverbindung geschont wird.

Dadurch können die von der mindestens einen Steckverbindung aufgenommen Querkräfte senkrecht zur Einschubrichtung maßgeblich gesenkt und insbesondere begrenzt werden, denn sobald eine maximal durch das Zusammenspiel von Endabschnitt und Öffnung zugelassene Auslenkung der Modulrückwand gegenüber der Backplane-Platine senkrecht zur Einschubrichtung erreicht ist, werden zusätzliche Querkräfte senkrecht zur Einschubrichtung von dem Endabschnitt und der Öffnung von dem Gehäuse auf die Modulrückwand übertragen und nicht von der mindestens einen Steckverbindung. Dies ist insbesondere deshalb vorteilhaft, da die mindestens eine Steckverbindung zwischen Steckkontakt der Modulrückwand und Steckverbinder der Backplane-Platine besonders fehler- und defektanfällig ist.

Gemäß der Erfindung ist der Vorsprung fest an der Gehäuserückwand angeordnet, wenn dieser fest mit der Gehäuserückwand verbunden ist und/oder teilweise oder komplett als Teil der Gehäuserückwand ausgebildet ist.

Bei den meisten Steckverbindungen, wobei die mindestens eine Steckverbindung vorzugsweise als derartige Steckverbindung ausgebildet ist, weist zumindest der Steckkontakt oder der Steckverbinder ein federndes Kontaktelement auf, das den Kontakt zum Kontaktelement des anderen herstellt. Vorzugsweise ist dabei dann die Auslenkung der Modulrückwand gegenüber der Backplane-Platine senkrecht zur Einschubrichtung derart durch das Zusammenspiel des Endabschnitts und der Öffnung begrenzt, dass ein Federweg eines federnden Kontaktelements des zumindest einen Steckkontakts oder des zumindest einen Steckverbinders größer 0 bleibt. Dadurch wird die mindestens eine Steckverbindung besonders geschont, da zumindest in der Richtung des Federwegs des federnden Kontaktelements der Anteil der Querkraft, der durch die Steckverbindung aufgenommen wird, ausschließlich federnd aufgenommen wird.

Vorteilhafte Ausführungsformen der vorliegenden Erfindung sind Gegenstand der Unteransprüche.

In einer bevorzugten Ausführungsform ist eine Stecktoleranz der mindestens einen Steckverbindung größer als ein Spiel zwischen dem Endabschnitt und der Öffnung ausgebildet, wobei die Stecktoleranz vorzugsweise mindestens um 5% und/oder um 0,005 mm größer als das Spiel zwischen dem Endabschnitt und der Öffnung ist. Dadurch wird die mindestens eine Steckverbindung besonders effektiv geschont, da keine Querkraftübertragung zwischen nicht federnden Elementen des Steckverbinders und des Steckkontakts erfolgt.

Gemäß einer weiteren besonders bevorzugten Ausführungsform ist der Endabschnitt durch einen Passstift und die Öffnung durch eine Passbohrung ausgebildet ist, wobei eine Passung zwischen dem Passstift und der Passbohrung eine Presspassung, Übergangspassung oder vorzugsweise eine Spielpassung ist, wobei die Spielpassung weiter bevorzugt maximal ein Spiel einer Spielpassung vom Typ H7/g6, besonders bevorzugt maximal das Spiel einer Spielpassung vom Typ H7/h6, aufweist. Dabei muss die Passbohrung über das Modul per Hand auf den Passstift geschoben werden können. Durch eine derartige Ausbildung des Endabschnitts und der Öffnung kann die mögliche Auslenkung der Modulrückwand gegenüber der Backplane-Platine genau eingestellt werden. Daneben sind die benötigten Fertigungsverfahren des Endabschnitts und der Öffnung aus dem Stand der Technik bekannt.

Gemäß einer bevorzugten Ausführungsform weist die Gehäuserückwand zwei Stifte auf, auf die die Backplane-Platine aufgesteckt ist und durch die eine Backplane-Platinen-Position der Backplane-Platine relativ zur Gehäuserückwand und zu dem Vorsprung festgelegt ist, und ist mindestens ein Positionierelement mit mindestens einem Positioniervorsprung an der Modulrückwand angeordnet, an dem die Modulplatine derart anliegt, dass der Positioniervorsprung in eine Senkbohrung in der Modulplatine greift und dass eine Modulplatinen-Position der Modulplatine relativ zur Modulrückwand und der Öffnung festgelegt ist. Dadurch ist die Position des mindestens einen Steckverbinders zum Vorsprung und die Position des mindestens einen Steckkontakts zur Öffnung festgelegt. Entsprechend ergibt sich eine sichere und widerholbare Verbindung der mindestens einen Steckverbindung, wenn die Öffnung des Moduls auf den Endabschnitt aufgeschoben wird.

Vorzugsweise sind mindesten zwei Positionierelemente mit jeweils mindestens einem, vorzugsweise zwei, Positioniervorsprung an der Modulrückwand angeordnet, an denen die Modulplatine derart anliegt, dass die Positioniervorsprünge in Bohrungen, vorzugsweise Senkbohrungen, in der Modulplatine greifen und dass eine Modulplatinen-Position der Modulplatine relativ zur Modulrückwand und der Öffnung festgelegt ist. Die Positionierelemente können dabei an die Modulrückwand geschraubt sein.

In einer weiteren Ausführungsform weist das Gehäuse zwei parallele Gehäuseseitenwände auf, die in Einschubrichtung von der Gehäuserückwand abstehen und zwischen die das Modul in Einschubrichtung in das Gehäuse einführbar ist, wobei das Modul eine Modulvorderwand aufweist, die mit der Modulplatine auf einer der Modulrückwand gegenüberliegenden Seite verbunden ist und die mit den der Gehäuserückwand gegenüberliegenden Enden der Gehäuseseitenwände verschraubbar ist, wenn sich das Modul in der Endposition befindet, wobei die Modulplatine vorzugsweise senkrecht zu der Gehäuserückwand und den Gehäuseseitenwände ausgerichtet ist, wenn sich das Modul in der Endposition befindet. Dadurch kann das Modul sicher in und an dem Gehäuse befestigt werden.

In einer bevorzugten Ausführungsform ist die Modulplatine senkrecht zur Modulrückwand angeordnet und der Vorsprung mittig an der Gehäuserückwand angeordnet, wobei der Vorsprung vorzugsweise mittig zwischen den Gehäuseseitenwänden angeordnet ist. Dabei handelt es sich um eine vorteilhafte Anordnung der einzelnen Komponenten des Backplane-Systems. Durch die mittige Anordnung des Vorsprungs ergibt sich eine vorteilhafte Übertragung der Querkräfte vom Gehäuse auf die Modulrückwand.

Gemäß einer weiteren bevorzugten Ausführungsform weist das Modul zwei Modulseitenwände auf, die zwischen der Modulrückwand und der Modulvorderwand angeordnet sind, wobei die Gehäuseseitenwände einen Führungsvorsprung entlang der Einschubrichtung und die Modulseitenwände eine Führungsnut entlang der Einschubrichtung aufweisen, die bei dem Einführen des Moduls in das Gehäuse ineinandergreifen. Dadurch ist das Modul zum einen in sich stabiler und die Modulplatine muss weniger Kräfte aufnehmen. Daneben kann das Modul auf einfache und geführte Weise in Einschubrichtung in das Gehäuse eingeführt werden.

In einer bevorzugten Ausführungsform bildet der Vorsprung einen ersten Anschlag in der Einschubrichtung angrenzend an den Endabschnitt aus, sodass die Modulrückwand an dem ersten Anschlag aufliegt, wenn sich das Modul in der Endposition befindet. Dadurch ist die Position des Moduls gegenüber der Gehäuserückwand in der Einschubrichtung begrenzt und die mindestens eine Steckverbindung kann derart eingerichtet werden, dass keine übermäßigen Kräfte auf sie in der Einschubrichtung erfolgen. Dies erhöht die Lebensdauer des Backplane-Systems.

In einer bevorzugten Ausführungsform ist der Passstift, der den Endabschnitt bildet, in einer Bohrung im ersten Anschlag befestigt. Dies vereinfacht die Fertigung und der Passstift kann als Standardelement in großer Stückzahl gefertigt werden. Vorzugsweise ist der Vorsprung außer dem Passstift als Teil der Gehäuserückwand ausgebildet. Dadurch ist der Vorsprung teilweise Teil des Gehäuses und es erfolgt eine bauteilinterne Kraftübertragung. Zudem müssen weniger einzelne Komponenten gefertigt und miteinander verbunden werden, was den Aufbau des Backplane-Systems vereinfacht.

Weitervorzugsweise ist die Gehäuserückwand und der Vorsprung außer dem Passstift als Teil der Gehäuserückwand als Frästeil gefertigt. Dies ermöglicht eine effiziente Fertigung.

In einer besonders bevorzugten Ausführungsform bildet die Gehäuserückwand eine Aussparung hinter der Backplane-Platine aus, in der weitere Steckverbinder an der Backplane-Platine anbringbar sind, wobei vorzugsweise der Vorsprung in der Aussparung angeordnet ist und einen zweiten Anschlag in der Einschubrichtung ausbildet, an dem die Backplane-Platine aufliegt. Dadurch kann die Backplane-Platine auf einfache Weise mit weiteren Steckverbindern bestückt werden.

Gemäß einer bevorzugten Ausführungsform ist die Aussparung in einer Anschlussrichtung senkrecht zur Einschubrichtung und senkrecht zu einer Normalen auf den Gehäuseseitenwänden von Außerhalb des Gehäuses zugänglich und weisen die weiteren Steckverbinder eine Verbindungsrichtung in Anschlussrichtung auf. Dadurch können die weiteren Steckverbinder auf effiziente Weise mit Anschlüssen zu vom Backplane-System externen Geräten verbunden werden.

Vorzugsweise weisen die weiteren Steckverbinder ein Abstand zu einem Boden der Aussparung auf, wobei der Abstand vorzugsweise derart ausgelegt ist, dass die weiteren Steckverbinder den Boden der Aussparung nicht berühren, falls die Backplane-Platine durch äußere Krafteinflüsse auf das Gehäuse schwingt.

In einer weiteren besonders bevorzugten Ausführungsform ist zumindest ein Federbolzen derart an der Gehäuserückwand angeordnet, dass dieser eine Federkraft entgegen der Einschubrichtung auf die Modulrückwand ausübt, wenn sich das Modul in der Endposition befindet. Dadurch kann insbesondere die Befestigung des Moduls gegenüber dem Gehäuse hinsichtlich Vibrationen auf das Gehäuse verbessert werden.

Vorzugsweise ist der Federbolzen derart ausgebildet, dass dieser das Modul derart entgegen der Einschubrichtung aus dem Gehäuse schiebt, wenn das Modul nicht an dem Gehäuse befestigt ist, dass die mindesten eine Steckverbindung gelöst wird und sich das Modul aus der Endposition bewegt. Dadurch bedarf es keines aufwendigen und defektanfälligen Auswerfmechanismus, wie die oft verwendeten Hebelmechanismen, zum Auswerfen des Moduls gegenüber dem Gehäuse.

In einer bevorzugten Ausführungsform ist der Federbolzen in einer Aufnahme in der Gehäuserückwand befestigt und reicht durch die Backplane-Platine. Dadurch kann ein kompakter Aufbau des Backplane-Systems erreicht werden.

Gemäß einer weiteren Ausführungsform weist das Backplane-System zwei Federbolzen auf, die symmetrisch zu dem Vorsprung an der Gehäuserückwand angeordnet sind. Dies ermöglicht eine symmetrische Kraftübertragung der Federbolzen auf die Modulrückwand.

In einer bevorzugten Ausführungsform weist das das Backplane-System mindestens ein zweites Modul auf, wobei das zweite Modul in das Gehäuse in einer Einschubrichtung einführbar ist und eine zweite Modulplatine aufweist, die mit einer zweiten Modulrückwand verbunden ist, die mindestens einen zweiten Steckkontakt aufweist, wobei der mindestens eine zweite Steckkontakt mit einem Steckverbinder der Backplane-Platine mindestens eine zweite Steckverbindung ausbildet, wenn das jeweilige Modul in der Einschubrichtung in eine Endposition in das Gehäuse eingeschoben ist, wobei ein zweiter Vorsprung fest an der Gehäuserückwand angeordnet ist, der durch die Backplane-Platine reicht und einen von der Gehäuserückwand entfernten zweiten Endabschnitt aufweist, der in eine zweite Öffnung in der zweiten Modulrückwand in Einschubrichtung einführbar ist, wenn das zweite Modul in Einschubrichtung in die Endposition gebracht wird, wobei der zweite Endabschnitt und die zweite Öffnung derart ausgebildet sind, dass diese eine Auslenkung der zweiten Modulrückwand gegenüber der Backplane-Platine senkrecht zur Einschubrichtung derart begrenzen, dass die mindestens eine zweite Steckverbindung geschont wird. Derart kann das Backplane-System mehrere Module umfassen, die eine erhöhte Lebensdauer in Umgebungen, die Vibrationen und/oder Stößen ausgesetzt sind, aufweisen. Die oben gezeigten Ausführungsbeispiele, die sich auf das Zusammenspiel des Moduls und des Gehäuses beziehen, können auf gleiche Weise auch für das mindestens eine zweite Modul ausgebildet sein.

Gemäß einer bevorzugten Ausführungsform ist der Endabschnitt des Vorsprungs und der zweite Endabschnitt des zweiten Vorsprungs jeweils als Passstift ausgebildet und ist der Vorsprung und der zweite Vorsprung außer dem Passstift als Teil der Gehäuserückwand ausgebildet. Dies vereinfacht die Fertigung des Backplane-Systems und macht dieses weniger defektanfällig.

Ein Ausführungsbeispiel der Erfindung wird im Folgenden anhand von Zeichnungen näher erläutert.

Es zeigen:
- Figur 1a: Schnittansicht von oben auf ein erfindungsgemäßes Ausführungsbeispiel des Backplane-Systems, wobei sich das Modul nicht in der Endposition befindet und die Schnittebene den Passstift schneidet,
- Figur 1b: Schnittansicht von oben auf das erfindungsgemäße Ausführungsbeispiel des Backplane-Systems gezeigt in Figur 1a, wobei sich das Modul nicht in der Endposition befindet und die Schnittebene die Befestigungsschrauben schneidet,
- Figur 2a: Schnittansicht von oben auf das erfindungsgemäße Ausführungsbeispiel des Backplane-Systems gezeigt in Figur 1a, wobei sich das Modul in der Endposition befindet und die Schnittebene den Passstift schneidet,
- Figur 2b: Schnittansicht von oben auf das erfindungsgemäße Ausführungsbeispiel des Backplane-System gezeigt in Figur 1a, wobei sich das Modul in der Endposition befindet und die Schnittebene die Befestigungsschrauben schneidet, und

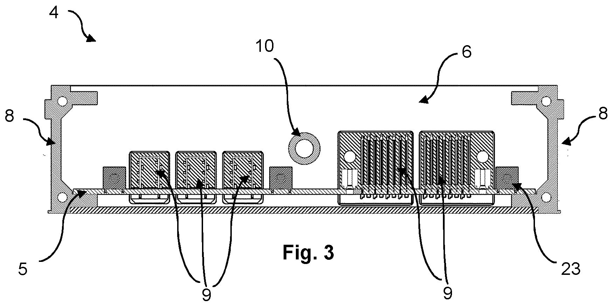

- Figur 3: Schnittansicht eines Moduls des erfindungsgemäßen Ausführungsbeispiels des Backplane-Systems in Einschubrichtung in der Schnittebene A1, wobei die Schnittebene A1 in Figur 2b eingezeichnet ist.

Für die folgenden Ausführungen gilt, dass gleiche Teile durch gleiche Bezugszeichen bezeichnet werden. Sofern in einer Figur Bezugszeichen enthalten sind, auf die in der zugehörigen Figurenbeschreibung nicht näher eingegangen wird, so wird auf vorangehende oder nachfolgende Figurenbeschreibungen Bezug genommen.

Die Figuren zeigen ein Ausführungsbeispiel eines erfindungsgemäßen Backplane-Systems 1, das ein Gehäuse, mit einer Gehäuserückwand 2 und zwei Gehäuseseitenwänden 3, wobei das Gehäuse eine nicht gezeigte Gehäuseoberwand und Gehäuseunterwand aufweisen kann, und ein Modul 4 aufweist.

Das Modul 4 weist dabei eine Modulplatine 5 auf, die mit einer Modulrückwand 6, einer Modulvorderwand 7 und zwei Modulseitenwänden 8 verbunden ist. Die Modulrückwand 6 weist dabei wiederum mehrere Steckkontakte 9 und eine Öffnung in der Form einer Passbohrung 10 in einer Buchse auf. Die Modulvorderwand 7 weist mehrere Anschlüsse 11 für externe Komponenten auf. An den Modulseitenwänden 8 sind jeweils eine Führungsnut 12 zur Führung gegenüber den Gehäuseseitenwänden 3 ausgebildet. Zur Positionierung der Modulplatine 5 gegenüber der Modulrückwand 6 und entsprechend gegenüber der Passbohrung 10 sind drei Positionierelemente 23 mittels einer Bohrung an der Modulrückwand 6 befestigt. Die Positionierelemente 23 weisen jeweils zwei Positioniervorsprünge auf und die Modulplatine ist derart an den drei Positionierelementen angeordnet, dass die Positioniervorsprünge in Bohrungen in der Modulplatine 5 greifen. Entsprechend ist die Position der Modulplatine 5 gegenüber der Passbohrung 10 durch die drei Positionierelemente festgelegt, indem vorzugsweise drei Senkbohrungen in der Modulrückwand die Rückwand zu den Positionierelementen auf der Modulplatine spielfrei ausrichten.

In dem Gehäuse ist an der Gehäuserückwand 2 eine Backplane-Platine 13 angebracht. Hierfür weist die Gehäuserückwand 2 zwei Stifte auf, auf die die Backplane-Platine 13 aufgesteckt ist. In dieser Position ist die Backplane-Platine 13 dann mittels Backplane-Schrauben an die Gehäuserückwand geschraubt. Die Backplane-Platine 13 weist mehrere Steckverbinder 14 auf, die mit den jeweiligen Steckkontakten 9 der Module 4 Steckverbindungen ausbilden. Daneben sind an der Gehäuserückwand 2 Federbolzen 15 angeordnet, die durch die Backplane-Platine 13 reichen. Weiter bildet die Gehäuserückwand 2 eine Aussparung 16 hinter der Backplane-Platine 13 aus, in der ein Vorsprung 17 ausgebildet ist, der teilweise als Teil der Gehäuserückwand 2 ausgebildet ist und durch die Backplane-Platine 13 reicht. Dabei ist ein Endabschnitt des Vorsprungs 17 als Passstift 18 ausgebildet, der in einer Bohrung im restlichen Teil des Vorsprungs 17 befestigt ist. Daneben sind in der Aussparung 16 weitere Steckverbinder 19 an einer Rückseite der Backplane-Platine 13 angeordnet. Diese weiteren Steckverbinder 19 sind von einer Richtung parallel zu den Gehäuseseitenwänden 3 und der Gehäuserückwand 2 von außerhalb des Gehäuses zugänglich, sodass externe Komponenten über die weiteren Steckverbinder 19 mit dem Backplane-System 1 verbunden werden können. An den Gehäuseseitenwänden 3 sind Führungsvorsprünge 20 zur Führung des Moduls 4 angeordnet.

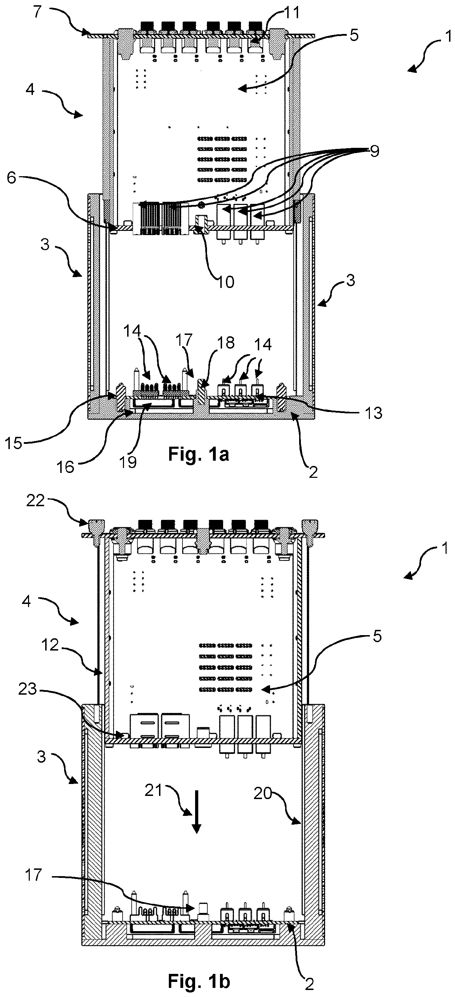

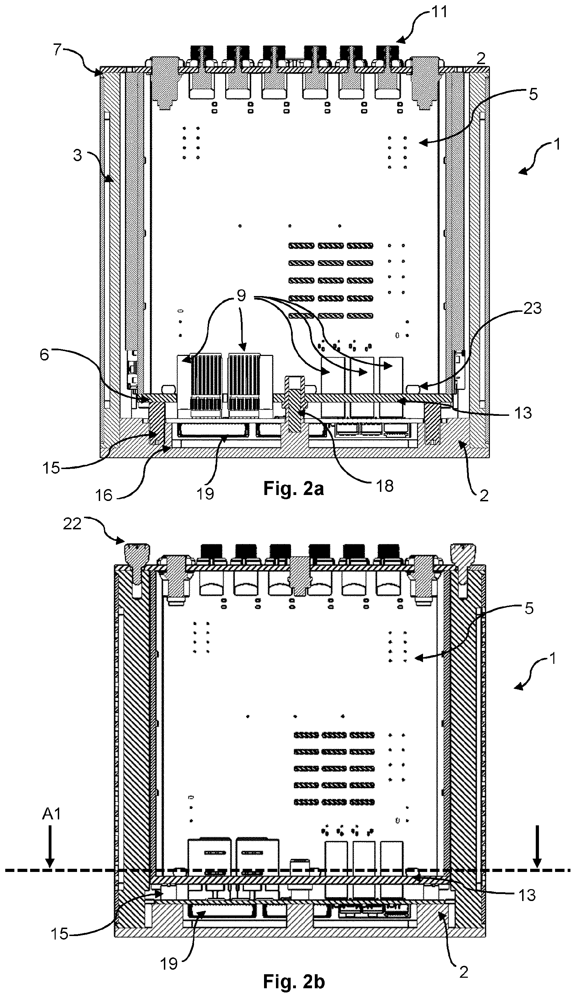

Wie das Modul 4 in das Gehäuse eingeführt und ausgeführt wird und wie das Modul 4 in dem erfindungsgemäßen Ausführungsbeispiel des Backplane-Systems 1 vorteilhafterweise befestigt wird, wird im Folgenden anhand den in den Figuren 1a, 1b, 2a und 2b gezeigten Schnittansichten beschrieben.

Figur 1a und 1b zeigen ein Modul 4, dass sich nicht in der Endposition befindet. Aus dieser Position ist das Modul in Einschubrichtung 21 in das Gehäuse zwischen die Gehäuseseitenwände 3 einführbar, bis es eine in den Figuren 2a und 2b gezeigte Endposition erreicht, in der die Stecckontakte 9 und Steckverbinder 14 miteinander verbunden sind.

In der Figur 1a ist der Aufbau es Vorsprungs 17 ersichtlich. Der Vorsprung 17 ist teilweise als Teil der Gehäuserückwand 2 ausgebildet, wobei dieser Teil des Vorsprungs 17 einen zweiten Anschlag in Einschubrichtung 21 ausbildet, an dem die Backplane-Platine 13 aufliegt und einen ersten Anschlag in Einschubrichtung 21 ausbildet, in dem die Bohrung zur Befestigung des Passstifts 18 sitzt.

Zur Führung während dem Einführvorgang weisen, wie oben beschrieben, die Modulseitenwände 8 Führungsnuten 12 und die Gehäuseseitenwände 3 Führungsvorsprünge 20 auf, die parallel zur Einschubrichtung 21 verlaufen. Weiter wird die Passbohrung 10 zum Ende des Einführvorgangs auf den Passstift 18 geschoben, bis die Modulrückwand 6 an dem ersten Anschlag des Vorsprungs 17 anliegt. Dies ist dann auch gleichbedeutend mit der Endposition. In dieser Position wird die Modulvorderwand 7 mit den Gehäuseseitenwänden 3 mittels der Befestigungsschrauben 22 verschraubt.

Wenn das Modul 4 in die Endposition gebracht wird, greifen zwei symmetrisch angeordnete Federbolzen 15 an der Modulrückwand 6 an und pressen diese und damit das Modul 4 gegen die Verschraubung. Dadurch wird die Verschraubung vorgespannt und löst sich deutlich seltener bei Vibrationen des Gehäuses. Daneben löst sich die Verbindung zwischen den Steckkontakten 9 und den Steckverbindern 14 durch die Kraft der Federbolzen 15, wenn die Verschraubung gelöst wird, sodass das Modul 4 dann leicht und ohne zusätzliche Mechanismen aus dem Gehäuse entfernt werden kann.

Die Passung zwischen der Passbohrung 10 und dem Passstift 18, die vorzugsweise eine Spielpassung des Typs H7/h6 ist, ist derart ausgebildet, dass diese eine Auslenkung senkrecht zur Einschubrichtung 21 der Modulrückwand 8 gegenüber der Backplane-Platine 13 begrenzt. Dies erfolgt derart, dass die Steckverbindungen zwischen den Steckkontakten 9 und Steckverbindern 14 nur sehr begrenzt Querkräfte senkrecht zur Einschubrichtung 21 vom Gehäuse auf die Modulrückwand 6 übertragen und die zusätzlichen Querkräfte senkrecht zur Einschubrichtung 21 dann nur von dem Vorsprung 17 über die Passbohrung 10 übertragen werden. Dadurch werden die Steckverbindungen geschont, die die fehleranfälligsten Komponenten des Backplane-Systems 1 darstellen. Dies ist in Umgebungen, in denen das Backplane-System 1 Vibrationen und Schlägen ausgesetzt ist, besonders relevant und vorteilhaft.

Ein Teil der Steckverbinder 14 und ein Teil der Steckkontakte 9 weist federnde Kontaktelemente auf, wobei jede Steckverbindung zumindest ein federndes Kontaktelement aufweist. Diese federnden Kontaktelemente sind im in den Figuren gezeigten Ausführungsbeispiel des Backplane-Systems 1 derart angeordnet, dass sie Federwege senkrecht zur Einschubrichtung 21 und in der in den Figuren 6 und 7 gezeigten Ebene aufweisen. Dabei ist die Passung zwischen der Passbohrung 10 und dem Passstift 18 derart ausgebildet, dass diese nur eine derartige Auslenkung der Modulrückwand 6 gegenüber der Backplane-Platine 13 in der Richtung dieser Federwege zulassen, dass diese Federwege stets größer 0 bleiben.

### Bezugszeichen

- 1: Backplane-System
- 2: Gehäuserückwand
- 3: Gehäuseseitenwand
- 4: Modul
- 5: Modulplatine
- 6: Modulrückwand
- 7: Modulvorderwand
- 8: Modulseitenwand
- 9: Steckkontakt
- 10: Passbohrung
- 11: Anschluss
- 12: Führungsnut
- 13: Backplane-Platine
- 14: Steckverbinder
- 15: Federbolzen
- 16: Aussparung
- 17: Vorsprung
- 18: Passstift
- 19: weitere Steckverbinder
- 20: Führungsvorsprung
- 21: Einschubrichtung
- 22: Befestigungsschraube
- 23: Positionierelement

## Patentansprüche

1. Backplane-System für Umgebungen, die Vibrationen und/oder Stößen ausgesetzt sind, das ein Gehäuse, das eine Gehäuserückwand aufweist, an der eine Backplane-Platine mit mindestens einem Steckverbinder befestigt ist, und ein Modul aufweist, das in das Gehäuse in einer Einschubrichtung einführbar ist und eine Modulplatine aufweist, die mit einer Modulrückwand verbunden ist, die mindestens einen Steckkontakt aufweist, wobei der mindestens eine Steckkontakt mit dem mindestens einen Steckverbinder mindestens eine Steckverbindung ausbildet, wenn das Modul in der Einschubrichtung in eine Endposition in das Gehäuse eingeschoben ist, **dadurch gekennzeichnet, dass** ein Vorsprung fest an der Gehäuserückwand angeordnet ist, der durch die Backplane-Platine reicht und einen von der Gehäuserückwand entfernten Endabschnitt aufweist, der in eine Öffnung in der Modulrückwand in Einschubrichtung einführbar ist, wenn das Modul in Einschubrichtung in die Endposition gebracht wird, wobei der Endabschnitt und die Öffnung derart ausgebildet sind, dass diese eine Auslenkung der Modulrückwand gegenüber der Backplane-Platine senkrecht zur Einschubrichtung derart begrenzen, dass die mindestens eine Steckverbindung geschont wird.

2. Backplane-System gemäß Anspruch 1, **dadurch gekennzeichnet, dass** eine Stecktoleranz der mindestens einen Steckverbindung größer als ein Spiel zwischen dem Endabschnitt und der Öffnung ausgebildet ist, wobei die Stecktoleranz vorzugsweise mindestens um 5% und/oder um 0,005 mm größer als das Spiel zwischen dem Endabschnitt und der Öffnung ist.

3. Backplane-System gemäß Anspruch 2, **dadurch gekennzeichnet, dass** der Endabschnitt durch einen Passstift und die Öffnung durch eine Passbohrung ausgebildet ist, wobei eine Passung zwischen dem Passstift und der Passbohrung eine Presspassung, Übergangspassung oder vorzugsweise eine Spielpassung ist, wobei die Spielpassung weiter bevorzugt maximal ein Spiel einer Spielpassung vom Typ H7/g6, besonders bevorzugt maximal das Spiel einer Spielpassung vom Typ H7/h6, aufweist.

4. Backplane-System gemäß einem der Ansprüche 1 bis 3, **dadurch gekennzeichnet, dass** die Gehäuserückwand zwei Stifte aufweist, auf die die Backplane-Platine aufgesteckt ist und durch die eine Backplane-Platinen-Position der Backplane-Platine relativ zur Gehäuserückwand und zu dem Vorsprung festgelegt ist, und mindestens ein Positionierelement mit mindestens einem Positioniervorsprung an der Modulrückwand angeordnet ist, an dem die Modulplatine derart anliegt, dass der Positioniervorsprung in eine Senkbohrung in der Modulplatine greift und dass eine Modulplatinen-Position der Modulplatine relativ zur Modulrückwand und der Öffnung festgelegt ist.

5. Backplane-System gemäß einem der Ansprüche 1 bis 4, **dadurch gekennzeichnet, dass** das Gehäuse zwei parallele Gehäuseseitenwände aufweist, die in Einschubrichtung von der Gehäuserückwand abstehen und zwischen die das Modul in Einschubrichtung in das Gehäuse einführbar ist, wobei das Modul eine Modulvorderwand aufweist, die mit der Modulplatine auf einer der Modulrückwand gegenüberliegenden Seite verbunden ist und die mit den der Gehäuserückwand gegenüberliegenden Enden der Gehäuseseitenwände verschraubbar ist, wenn sich das Modul in der Endposition befindet, wobei die Modulplatine vorzugsweise senkrecht zu der Gehäuserückwand und den Gehäuseseitenwände ausgerichtet ist, wenn sich das Modul in der Endposition befindet.

6. Backplane-System gemäß einem der Ansprüche 1 bis 5, **dadurch gekennzeichnet, dass** die Modulplatine senkrecht zur Modulrückwand angeordnet ist und der Vorsprung mittig an Gehäuserückwand angeordnet ist, wobei der Vorsprung vorzugsweise mittig zwischen den Gehäuseseitenwänden angeordnet ist.

7. Backplane-System gemäß Anspruch 6, **dadurch gekennzeichnet, dass** das Modul zwei Modulseitenwände aufweist, die zwischen der Modulrückwand und der Modulvorderwand angeordnet sind, wobei die Gehäuseseitenwände einen Führungsvorsprung entlang der Einschubrichtung und Modulseitenwände eine Führungsnut entlang der der Einschubrichtung aufweisen, die bei dem Einführen des Moduls in das Gehäuse ineinandergreifen.

8. Backplane-System gemäß einem der Ansprüche 1 bis 7, **dadurch gekennzeichnet, dass** der Vorsprung einen ersten Anschlag in der Einschubrichtung angrenzend an den Endabschnitt ausbildet, sodass die Modulrückwand an dem ersten Anschlag aufliegt, wenn sich das Modul in der Endposition befindet.

9. Backplane-System gemäß Anspruch 4 und 8, **dadurch gekennzeichnet, dass** der Passstift, der den Endabschnitt bildet, in einer Bohrung im ersten Anschlag befestigt ist, wobei vorzugsweise der Vorsprung außer dem Passstift als Teil der Gehäuserückwand ausgebildet ist.

10. Backplane-System gemäß einem der Ansprüche 1 bis 9, **dadurch gekennzeichnet, dass** die Gehäuserückwand eine Aussparung hinter der Backplane-Platine ausbildet, in der weitere Steckverbinder an der Backplane-Platine anbringbar sind, wobei vorzugsweise der Vorsprung in der Aussparung angeordnet ist und einen zweiten Anschlag in der Einschubrichtung ausbildet, an dem die Backplane-Platine aufliegt.

11. Backplane-System gemäß Anspruch 10, **dadurch gekennzeichnet, dass** die Aussparung in einer Anschlussrichtung senkrecht zur Einschubrichtung und senkrecht zu einer Normalen auf den Gehäuseseitenwänden von Außerhalb des Gehäuses zugänglich ist und die weiteren Steckverbinder eine Verbindungsrichtung in Anschlussrichtung aufweisen.

12. Backplane-System gemäß einem der Ansprüche 1 bis 11, **dadurch gekennzeichnet, dass** zumindest ein Federbolzen derart an der Gehäuserückwand angeordnet ist, dass dieser eine Federkraft entgegen der Einschubrichtung auf die Modulrückwand ausübt, wenn sich das Modul in der Endposition befindet, wobei der Federbolzen vorzugsweise derart ausgebildet ist, dass dieser das Modul derart entgegen der Einschubrichtung aus dem Gehäuse schiebt, wenn das Modul nicht an dem Gehäuse befestigt ist, dass die mindesten eine Steckverbindung gelöst wird und sich das Modul aus der Endposition bewegt, wobei das Backplane-System vorzugsweise zwei Federbolzen aufweist, die symmetrisch zu dem Vorsprung an der Gehäuserückwand angeordnet sind.

13. Backplane-System gemäß Anspruch 12, **dadurch gekennzeichnet, dass** der Federbolzen in einer Aufnahme in der Gehäuserückwand befestigt ist und durch die Backplane-Platine reicht.

14. Backplane-System gemäß einem der Ansprüche 1 bis 13, **dadurch gekennzeichnet, dass** das Backplane-System mindestens ein zweites Modul aufweist, wobei das zweite Modul in das Gehäuse in einer Einschubrichtung einführbar ist und eine zweite Modulplatine aufweist, die mit einer zweiten Modulrückwand verbunden ist, die mindestens einen zweiten Steckkontakt aufweist, wobei der mindestens eine zweite Steckkontakt mit einem Steckverbinder der Backplane-Platine mindestens eine zweite Steckverbindung ausbildet, wenn das jeweilige Modul in der Einschubrichtung in eine Endposition in das Gehäuse eingeschoben ist, wobei ein zweiter Vorsprung fest an der Gehäuserückwand angeordnet ist, der durch die Backplane-Platine reicht und einen von der Gehäuserückwand entfernten zweiten Endabschnitt aufweist, der in eine zweite Öffnung in der zweiten Modulrückwand in Einschubrichtung einführbar ist, wenn das zweite Modul in Einschubrichtung in die Endposition gebracht wird, wobei der zweite Endabschnitt und die zweite Öffnung derart ausgebildet sind, dass diese eine Auslenkung der zweiten Modulrückwand gegenüber der Backplane-Platine senkrecht zur Einschubrichtung derart begrenzen, dass die mindestens eine zweite Steckverbindung geschont wird.

15. Backplane-System gemäß Anspruch 14, **dadurch gekennzeichnet, dass** der Endabschnitt des Vorsprungs und der zweite Endabschnitt des zweiten Vorsprungs jeweils als Passstift ausgebildet ist und der Vorsprung und der zweite Vorsprung außer dem Passstift als Teil der Gehäuserückwand ausgebildet ist.
